Europäisches Patentamt

European Patent Office

Office européen des brevets

(10)

(11) Publication number: **0 167 357**
**B1**

# EUROPEAN PATENT SPECIFICATION

(45) Date of publication of patent specification: **13.06.90**

(21) Application number: **85304595.3**

(22) Date of filing: **27.06.85**

(51) Int. Cl.⁵: **G 11 B 7/13,** G 11 B 7/12, G 11 B 7/08

(54) Photosensor devices and optical pick-ups.

(30) Priority: **30.06.84 JP 99285/84**

(43) Date of publication of application:
**08.01.86 Bulletin 86/02**

(45) Publication of the grant of the patent:
**13.06.90 Bulletin 90/24**

(84) Designated Contracting States:
**AT CH DE FR GB LI NL**

(56) References cited:
**EP-A-0 019 378**
**EP-A-0 057 339**
**EP-A-0 124 353**
**FR-A-2 497 379**
**GB-A-2 088 048**
**GB-A-2 120 493**

**TOUTE L'ELECTRONIQUE, no. 494, May 1984,
pages 45-49, Paris, FR; T. SENS "Les lasers à
semiconducteur dans les systèmes à disques
optiques"**

(73) Proprietor: **SONY CORPORATION**
**7-35 Kitashinagawa 6-Chome Shinagawa-ku
Tokyo 141 (JP)**

(72) Inventor: **Minami, Toshihiko c/o Patent Division
Sony Corporation 7-35 Kitashinagawa-6
Shinagawa-ku Tokyo (JP)**
Inventor: **Umezawa, Isao c/o Patent Division
Sony Corporation 7-35 Kitashinagawa-6
Shinagawa-ku Tokyo (JP)**
Inventor: **Shintani, Kenji c/o Patent Division
Sony Corporation 7-35 Kitashinagawa-6
Shinagawa-ku Tokyo (JP)**

(74) Representative: **Thomas, Christopher Hugo
et al
D Young & Co 10 Staple Inn
London WC1V 7RD (GB)**

# Description

This invention relates to photosensor devices and optical pick-ups incorporating such photosensor devices. Embodiments of the invention are particularly, but not exclusively, suitable for use in optical compact disc players.

In conventional compact disc players, the surface of the disc bears a number of substantially circular record tracks, each composed of a row of pits or bumps indicative of a recorded information signal. The signal recorded in a track is reproduced by irradiating the record track with a coherent light beam, advantageously a laser beam, which is then reflected from the disc surface in a modulated condition indicative of the recorded signal. The modulated reflected beam is directed to fall on a photosensor device, which generates electrical signals in response to the amount of light received. The recorded signal may then be recovered from these electrical signals.

An optical pick-up is provided in the compact disc player for generating the laser beam, focusing it onto the disc surface, and directing the modulated reflected beam to the photosensor device. The laser beam may be split into three parallel beams; a main beam and two auxiliary beams, which are focused through an objective lens onto the disc surface. The main beam is focused directly onto the record track and is used for reading the recorded signal and for focus servo control. The auxiliary beams are focused along the record track ahead of and behind the main beam and are used for tracking servo control. The reflected beams pass back through the objective lens and are then directed to the photosensor device for processing and reproducing of the information signal as represented in the modulated beams. The photosensor device within the optical pick-up is thus used not only for light detection in the modulated main beam to reproduce the information signal, but is also used for light detection in the main and auxiliary beams for focus servo control and tracking servo control in a three beam tracking system. Consequently, the photosensor device has a plurality of photosensitive elements, each receiving different portions of the reflected beams.

The compact disc player is contained in a generally rectangular housing or casing. If the optical pick-up is moved parallel to one side of the casing, this side must be at least as long as the diameter of the disc within plus one half the width of the objective lens in order to accommodate the optical pick-up at its outermost position with the objective lens centred over the outermost record track.

With the growing popularity of compact disc players, the trend has been towards reducing the size of the casing as much as possible. An advantageous compact disc player is disclosed in our European patent application no. 84302816.8 (0 124 353), whose disclosure is herein incorporated by reference. The compact disc player disclosed therein includes an optical pick-up whose structure and mounting allow the casing to be reduced to a minimum size. The optical pick-up shown therein is moved radially with respect to the disc, as is usual, but in a direction forming an acute angle with two opposed sides of the rectangular casing. The casing then takes the shape of a square with the disc inscribed therein.

When the optical pick-up is thus driven in this acutely angled direction, the optical paths of the three beams must be altered. To understand this, it must be appreciated that in order to use the main beam and the two auxiliary beams as described, the three beams must be focused on the surface of the disc to lie along a straight line substantially tangential to the record track or at a small constant angle relative thereto. As will be described in detail below, this requires that the three beams be rotated by a predetermined angle about the optical axis of the main beam. Physically, the three beams are emitted parallel to each other and parallel to the surface of the disc, but lie in a plane which is tilted so as to intersect the surface at a predetermined angle. When the three beams are reflected from the surface of the disc and reformed parallel to the disc surface, they again lie in the tilted plane. Therefore, it is necessary that the photosensor device be mounted with the photosensitive elements in a plane at the same predetermined angle in order properly to detect the reflected beams.

Advantageously, the photosensor device is an integrated circuit and the photosensitive elements are semiconductor portions therein. The photosensor integrated circuit or chip is fixed in a relatively large, transparent package mounted in turn on a circuit board. Each photosensitive element has a pair of terminal leads extending therefrom with external portions extending outside of the package for connection to the focus and tracking servo control circuits also mounted on the circuit board. Since the photosensor device must be mounted at the above mentioned predetermined angle relative to the surface of the disc, it is necessary to make a corresponding change in the wiring pattern of the circuit board. However, this significantly increases the space requirement for the package bearing the photosensor chip, thus limiting the reduction in size of the compact disc player.

According to the present invention there is provided a photosensor device comprising:

a rectangular package carrying a plurality of pairs of terminal leads, each terminal lead having an external portion extending outside of said package, said external portions being parallel to each other within a first plane and perpendicular to a first direction within said first plane;

photosensing means mounted on said package and having a surface substantially parallel to said first plane; and

a plurality of photosensitive elements formed on said surface and aligned thereon in a second direction;

each pair of terminal leads being electrically connected to a respective photosensitive element;

characterized in that:

said second direction is not parallel to a side of said package and forms an angle with respect to a projection of said first direction onto said surface, said angle being other than nπ/2, where n equals zero or a positive integer.

The invention will now be described by way of example with reference to the accompanying drawings, throughout which like parts are referred to by like references, and in which:

Figure 1 is a schematic elevational view of the optical system of a conventional optical pick-up for use in an optical compact disc player;

Figure 2 is a diagrammatic plan view of the optical system of an optical pick-up of a type in which the present invention may be embodied, and which is shown associated with a portion of an optical compact disc player;

Figure 3 is a front elevational view of a portion of the optical system of Figure 2;

Figure 4 is a diagrammatic plan view of another known type of optical compact disc player;

Figure 5 is a plan view of a first embodiment of a photosensor device according to the present invention;

Figure 6 is an enlarged plan view of a photosensor integrated circuit included in the photosensor device of Figure 5;

Figure 7 is an enlarged cross-sectional view taken along line III-III of Figure 6;

Figure 8 is a plan view of a second embodiment of photosensor device according to the present invention; and

Figure 9 is a diagrammatic plan view of a record track on the surface of the disc and beam spots formed thereon.

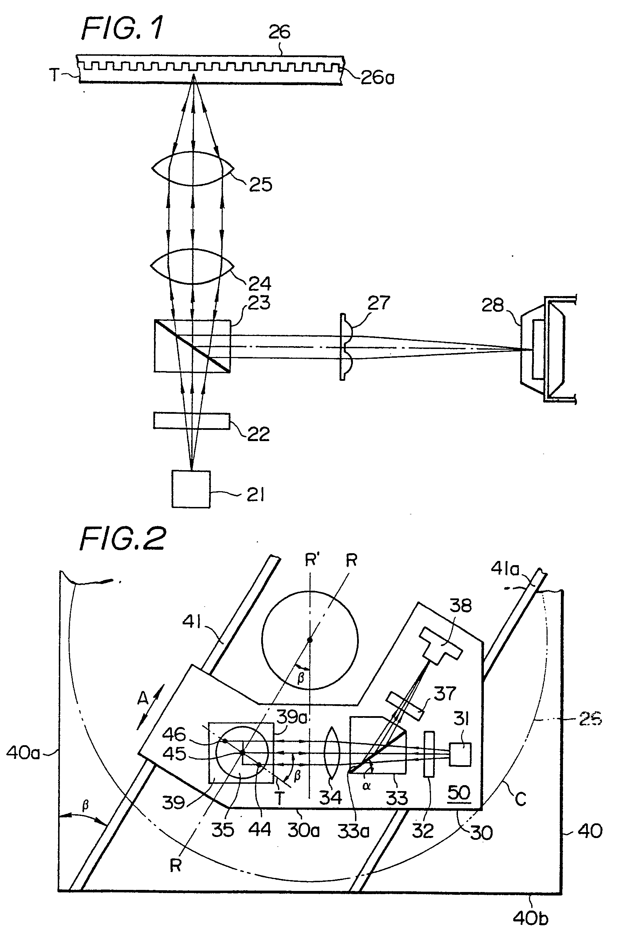

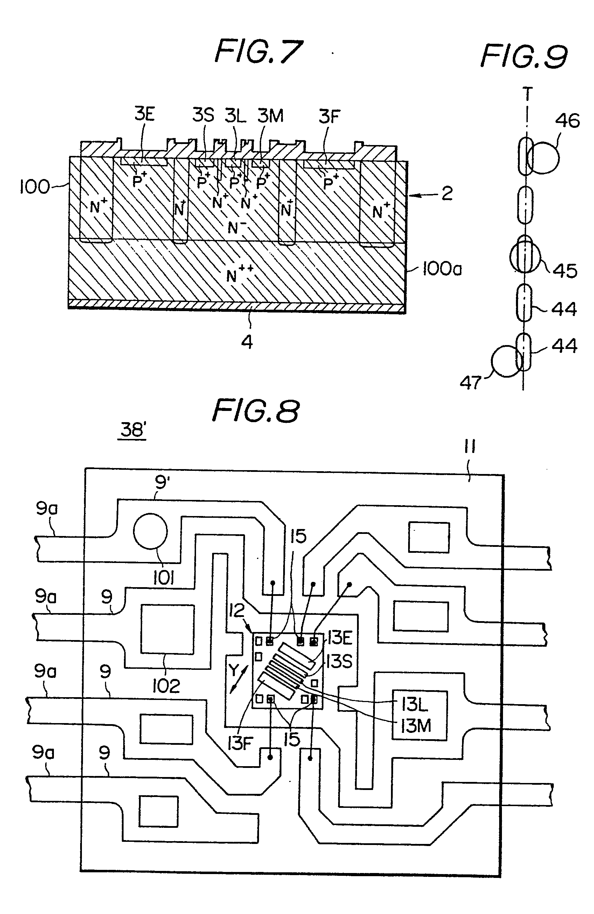

Referring now to the drawings and initially to Figure 1 thereof, the overall optical system of a conventional optical pick-up is shown to include a laser beam source 21, which may, for example, be a solid state laser or semiconductor laser, such as a laser diode. The laser beam source 21 emits a laser beam which is split by a diffraction grating 22 into three coherent light beams. These are a main beam, which is used for reproducing the information signal recorded on the optical disc and for focus servo control, and two auxiliary beams, one on either side of the main beam, used for tracking servo control. The three beams pass through a beam splitter 23, which acts as a half-mirror to pass the incident beams, but to reflect the return beams, as illustrated. The beams are aligned to be parallel by a collimation lens 24 and are focused by an objective lens 25 onto a record surface of a disc 26. The disc 26 has an information signal recorded thereon in the form of pits or identations, or bumps, schematically illustrated in Figure 1 as a square wave 26a, and which are arranged along substantially circular tracks, as at T in Figure 1. Each such track T may be a respective turn of a continuous spiral track arrangement on the disc 26. The main beam, as focused at a surface of the disc 26, forms a main beam spot 45 (Figure 9) intended to be centred on pits 44 of the track T, while the two auxiliary beams form auxiliary beam spots 46 and 47 lying ahead of and behind the main beam spot 45, respectively, at opposite sides of the track T. When the beams are reflected back from the surface, they are modulated by the pits 44 so as to be indicative of the recorded signal. As shown in Figure 1, the modulated return beams pass back through the objective lens 25 and the collimation lens 24 to the beam splitter 23 where they are reflected towards a double spot forming semi-cylindrical lens 27. The semi-cylindrical lens 27 splits each beam into two and directs the beams onto a photosensor device 28 so as to form a total of six separate beam spots. The photosensor device 28 includes photosensitive elements responsive to the light falling thereon in the six beam spots for producing electrical signals used for reproducing the information electrical signals used for reproducing the information signals and for focus and tracking servo control, as is conventional.

An improved optical pick-up 50 of the type disclosed in our patent application no. 84302816.8 (EP.A.0124353) referred to above, is diagrammatically illustrated in Figure 2 and shown to include a rectangular casing 40 which encloses and supports at least the disc 26 and the optical pick-up 50 of the compact disc player. In order to reduce the vertical height of the casing 40, the laser beam is emitted from a laser source 31 in a direction parallel to the surface of the disc 26 and parallel to one side 40b of the casing 40. By this means, most of the optical elements forming the optical system of the optical pickup 50 may be arranged parallel to the side 40b and to the surface of the disc 26, rather than perpendicular to the surface, as in the optical system of Figure 1, so that the height of the optical pick-up 50 and the casing 40 enclosing it may be reduced. These elements are mounted on a base plate 30 parallel to the disc surface and include the laser source 31, a diffraction grating 32, a beam splitter 33, a collimation lens 34, a double-spot forming semi-cylindrical lens 37 and a photosensor device 38, corresponding functionally to the similarly named elements illustrated in Figure 1.

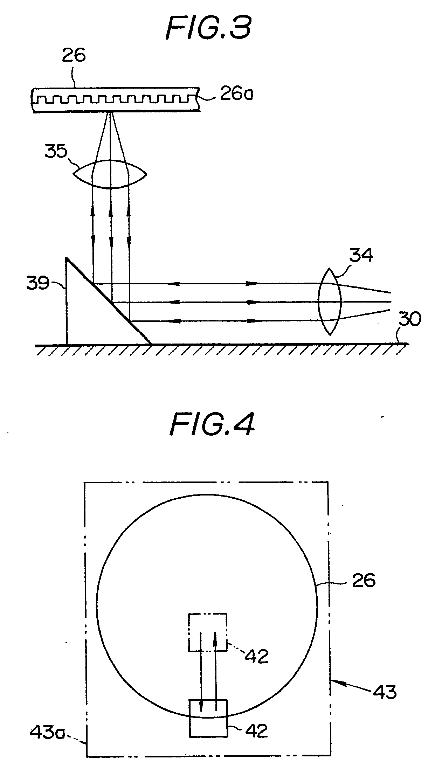

The optical system of the optical pick-up 50 additionally includes a mirror 39 arranged following the collimation lens 34 at a 45° angle to the disc surface. The mirror 39 serves to reflect the three beams by 90° to fall perpendicularly onto the disc surface. As may be more clearly seen in Figure 3, the base plate 30 and the disc 26 are parallel to each other and to the three beams exiting from the collimation lens 34. The three beams are reflected by the mirror 39 and are focused by an objective lens 35 onto the disc surface. As in the optical system of Figure 1, the beams are reflected in a modulated condition indicative of the information signal recorded in the track T on the disc surface, and pass back through the objective lens 35. They are again reflected at 90° from the mirror 39 and pass back through the collimation lens 34 to be deflected by the beam splitter 33 (Figure 2). In the illustrated embodiment, the beam splitter 33 has a half-mirror surface 33a which is inclined at an angle α less than 45° relative to the optical axis of the main beam. Therefore, the beams are deflected by an angle equal to 2α. The deflected beams pass through the semi-cylindrical lens 37 and fall on the photosensitive device 38 in two beam spots each. Thus, in the optical pick-up 50, only four elements, to wit, the base plate 30, the mirror 39, the objective lens 35 and the disc 26, need be arranged vertically one above the other. This enables a significant reduction in the vertical height of the casing 40.

A highly advantageous feature of the compact disc player incorporating the optical pick-up 50 illustrated in Figure 2 is that the optical pick-up 50 is mounted to be driven in the direction indicated by arrows A at an acute angle β with respect to a side 40a of the casing 40. To this end, the base plate 30 of the optical pick-up 50 is mounted on parallel guide shafts 41 and 41a which themselves are mounted at angle β with respect to the side 40a. The objective lens 35 is displaced from the guide shafts 41 and 41a so that it will be moved in a first radial direction R of the disc 26 forming the same angle β with respect to a second radial direction R' parallel to the side 40a. To read all the tracks T, the optical pick-up 50 is driven from an outermost position in which the objective lens 35 is centred over an outermost track to an innermost position in which the objective lens 35 is centred over an innermost track. Figure 2 illustrates the optical pick-up 50 in an intermediate position. However, it is easily seen that when the optical pick-up 50 is in its outermost position, a side 30a of the base plate 30 will abut the side 40b of the casing 40, and will not extend substantially beyond the outer circumference C of the disc 26. Therefore, the side 40a of the casing 40 does not have to be substantially longer than the diameter of the disc 26 itself, while still enclosing the entire optical pick-up 50.

This represents a significant advantage, as may be seen from Figure 4, which illustrates another type of compact disc player having an optical pick-up 42 which moves parallel to a side 43a of a casing 43. In order for the centre of an objective lens within the optical pick-up 42 to overlie the outermost track, the optical pick-up 42 must extend by at least the radius of the objective lens beyond the outermost track, as illustrated in solid lines in Figure 4. Thus, the side 43a must be longer by at least this distance to accommodate both the disc 26 and the radius of the objective lens.

In the compact disc player of Figure 2, the three beam spots 44, 45 and 46 formed by focusing the three beams onto the surface of the disc 26 should lie in a straight line tangential to the track T or at a small constant angle relative thereto. Figure 9 illustrates the correct positioning of the main beam spot 45 and the auxiliary beam spots 46 and 47. The main beam spot 45 is focused directly onto the centre of the track T, while the first auxiliary beam spot 46 lies ahead and a small distance to one side of the track T and the second auxiliary beam spot 47 lies behind and the same small distance to the other side of the track T. As is well known in conventional three beam tracking servo control mechanisms, the reflected beams contain information from which it is possible to determine whether or not the beam spots 45 to 47 are correctly aligned as in Figure 9. However, in order to achieve the correct placement of the beam spots 45 to 47 on the track T when using the optical pick-up 50, the plane defined by the three beams must be rotated.

This may be seen from Figure 2. The track T on the disc 26 is illustrated in greatly magnified form, with the main beam spot 45 and the auxiliary beam spots 46 and 47 lying in a straight line thereon. Of course, as shown in Figure 9, the straight line extending through the centres of the beam spots 45, 46 and 47 may not be exactly tangential to the track T, but in any event the beam spots 45 to 47 are all aligned along the same straight line, which for the purpose of this discussion may be taken as the track T. As illustrated in Figure 2, the main beam spot 45 fails on the radial direction R forming the angle β with the radial direction R' parallel to the side 40a. The mirror 39 is of course not parallel to the surface of the disc 26, but rather, as shown in Figure 3, is at a 45° angle thereto, with the side 39a parallel to the disc surface. If the three beams were to lie in a plane parallel to the disc surface, they would travel the same distance to reach the mirror 39 and would be incident thereon along a line parallel to the radial direction R', and consequently would be incident onto the disc surface in another straight line parallel thereto. This is not the case, but rather the three parallel beams lie in a plane tilted with respect to the disc surface, so that each travels a different distance before being incident on the mirror 39, and consequently are reflected therefrom so as to fall along the track T rather than along a line parallel with the radius R'. The track T at the point where it is impinged by the main beam spot 45, is perpendicular to the radial direction R. Upon reflection from the disc surface and further reflection from the mirror 39, the beams once again extend parallel to the record surface, and again lie in the same plane tilted relative to the record surface. Therefore, when the three beams pass back through the collimation lens 34 and are deflected by the beam splitter 33 to the semi-cylindrical lens 37 to fall on the photosensor device 38, they still lie in a plane tilted by the same angle with respect to the surface of the disc 26. Accordingly, the photosensitive elements of the photosensor device 38 must similarly be aligned within this tilted plane so as to receive the three beams in the correct orientation.

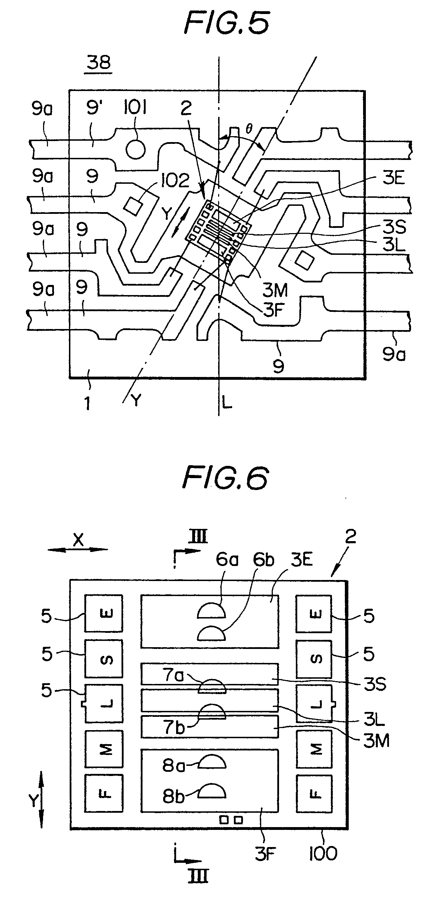

This orientation may be seen in a first embodiment of the photosensor device 38 according to the present invention, illustrated in Figures 5 to 7. Referring first to Figure 5, the photosensor device 38 includes a photosensor integrated circuit or chip 2, advantageously formed as a semiconductor integrated circuit. The chip 2 is encapsulated in a moulded package 1 made of transparent resin. A plurality of terminal leads 9 are carried by the package 1 and are affixed to the chip 2 within the package 1. The terminal leads 9 have external portions 9a extending outside the package 1.

As is more clearly seen in Figure 6, the chip 2 has five photosensitive elements 3E, 3S, 3L, 3M and 3F formed on a major planar surface thereof. The photosensitive elements 3E to 3F are advantageously formed of appropriately doped semiconductor regions having rectangular configurations at the planar surface, with two long sides of each photosensitive element 3E to 3F being parallel to a direction X in Figure 6, and two short sides being parallel to a direction Y. As illustrated in Figure 5, the direction Y is not parallel or perpendicular to any side of the package 1, but rather includes a chip mounting angle θ with respect to a direction L parallel to the sides of the package 1 from which the external lead portions 9a emerge. In addition, the external lead portions 9a are all parallel to each other and perpendicular to the direction L. Moreover, the chip mounting angle θ is selected so as not to be equal to nπ/2, where n is zero or a positive integer.

The chip mounting angle θ is further selected so that the three beams will fall on the photosensitive elements 3E to 3F in the alignment illustrated in Figure 6, that is, along a line centred between and parallel to the short sides of the rectangular elements 3E to 3F. As noted above, the semi-cylindrical lens 37 splits each beam into two beams, so that six resultant semi-circular beam spots will appear on the chip 2, as at 6a, 6b, 7a, 7b, 8a and 8b. In order for this proper alignment of beam spots relative to the photosensitive elements 3E to 3F to exist, the chip mounting angle θ defined between the alignment direction Y of the photosensitive portions 3E to 3F and the straight line L is selected as a function of the angle β between the optical path of the main beam in between the mirror 39 and the collimation lens 34, as shown in Figure 2, and the direction of the track T directly opposite the objective lens 35. More particularly, the chip mounting angle θ should be selected such that

$$\theta = (n\pi/2) + \beta$$

where n is 0 or a positive integer, and the tilt angle β is restricted such that

$$0° \text{ is less than } \beta \text{ is less than } 90°$$

For example, if the tilt angle β is equal to 30°, the chip mounting angle θ of the photosensor device may be 30°, 120°, 210° or 300°. The chip mounting angle θ is not dependent on the deflecting angle α of the beam splitter 33. Advantageously, the chip mounting angle θ is between 15° and 75°.

When the chip 2 is mounted with the photosensitive elements 3E to 3F at the chip mounting angle θ, the six beam spots 6a to 8b impinge on the photosensitive elements 3E to 3F along a line in the correct direction. Thus, the chip mounting angle θ is also the angle between the disc surface and the tilted plane containing the return optical beams after deflection from the beam splitter 33. It is not necessary to rotate the beams further following their reflection from the surface of the disc 26.

The structure of the chip 2 will now be described in greater detail in connection with Figures 6 and 7. As shown in Figure 6, the photosensitive elements 3E, 3S, 3L, 3M and 3S are formed as respective central rectangular photodiode portions. First and second anode portions 5 are mounted at opposite sides of the photosensitive elements on a base or substrate 100. As is more clearly seen in the cross-sectional view of Figure 7, the base 100 is formed of N⁻ type semiconductor material. The photosensitive elements 3E to 3F are P⁺ type semiconductor regions with isolation regions of N⁺ material electrically isolating them. Another region or layer 100a of N⁺⁺ type material is formed on the reverse side of the base 100, with a back electrode 4 serving as a common cathode for the five photosensitive elements 3E to 3F. The respective anode portions 5 are conventionally constructed as pads of aluminium or similar material for receiving the terminal leads 9. As is further shown in Figure 6, the six beam spots 6a to 8b fall on the five photodiodes 3E to 3F in a straight line along the Y direction, to produce a pattern thereon which may be used conventionally for focus and tracking servo control. The specific circuits by which the received pattern of beam spots is used for focus and tracking servo control does not form part of the present invention, and will not be described herein.

As illustrated in Figure 5, the chip 2 is mounted within the package 1 with the Y direction at the angle θ relative to the L direction so that the photosensitive portions 3E to 3F aligned in the Y direction will properly receive the three optical beams. However, the external lead portions 9a of the terminal leads 9 extending outside of the package 1 are arranged in a common plane within which they are perpendicular to the direction L and parallel to each other. Relative to the sides of the package 1, then, the external lead portions 9a have the same configuration as in a conventional photosensor package. Thus, the package 1 containing the chip 2 may be mounted on a circuit board bearing the focus and tracking servo control circuits and requires no more space therefor than do conventional photosensor packages. By virtue of the alignment of the chip 2 within the package 1 so that the photosensitive elements 3E to 3F are already aligned in the Y direction, the size of the circuit board, and consequently the size of the compact disc player itself, may be maintained at the minimum.

In the embodiment illustrated in Figure 5, the photosensitive elements 3E to 3F and the respective anode portions 5 are formed on the chip 2 with sides parallel or perpendicular to the sides of the chip 2 itself. However, this is not necessary, and a second embodiment of photosensor device 38' according to the present invention is illustrated in Figure 8. As shown therein, five photodiodes 13E, 13S, 13L, 13M and 13F are again aligned in the Y direction but now the sides of the photodiodes 13E to 13F are no longer parallel to the sides of a chip 12, but rather lie at the chip mounting angle θ relative thereto. The anode portions 15 are distributed on the chip 12 in the available space so as to be accessible to the terminal leads 9. In this second embodiment, the sides of the chip 12 are parallel to the sides of a package 11, so that the chip 12 may be sealed in the package 11 using a standard moulding die.

Another advantageous feature of each photosensor device 38 and 38' is that the first terminal leads 9 or 9' connected to one anode portion 5 or 15 of the first photosensitive element 3E or photodiode 13E may be indicated by a cut-out portion 101 therein having a different shape from the cut-out portion 102 of the remaining terminal leads 9 or 9'. As illustrated in Figures 5 and 8, the first cut-out portion 101 may be in the form of a circle, while the second cut-out portions 102 may be in the shape of a square.

Therefore, the alignment direction of the photosensitive elements within the photosensor device is rotated by a predetermined chip mounting angle β with respect to the package bearing the photosensor device. More precisely, this alignment direction is rotated by the chip mounting angle θ with respect to the straight line L, and the chip mounting angle θ is a function of the tilt angle β. Thus, when the photosensor device is used in an optical pick-up where return optical beams lie in a plane rotated by the chip mounting angle θ about the optical axis of the main beam, and are irradiated onto the photosensor device, the photosensitive elements thereof are already aligned in the correct direction, so that there is no need for the package bearing the photosensor device itself to be rotated for mounting. The result is that the space required for mounting the package on the circuit board is reduced to a minimum, and the wiring is simplified. In the second above-described embodiment of the photosensor device, the sides of the chip 12 are parallel to the sides of the package 11, so that standard mould dies for package moulding may be used.

It is of course possible to make the package 1 smaller than the standard size, with the photosensitive elements 3E to 3F mounted therein in the conventional position, that is without rotation and perpendicular to the direction of the terminal leads. Then the smaller package itself could be rotated for mounting and still be within the outer contour of the package 1 shown in Figure 5. However, with such smaller package, of course, only short portions of the terminal leads will be encapsulated by the package. Moreover, the resin used in transparent packages is relatively weak and lacks good moisture resistance, since reinforcing and moisture resistant fillers are generally not transparent and cannot be used. Thus the smaller package is prone to deterioration from moisture and may rupture, and the terminal leads are more easily pulled from the package. For acceptable operating reliability, the package should be substantially the conventional size. Therefore, it is highly advantageous that the photosensitive elements be mounted in the package at the chip mounting angle θ.

Of course, the package 1 need not be entirely transparent, but can be transparent only in that portion encapsulating the photosensitive elements 3E to 3F. Also, different types of optical pick-ups, other than the one specifically described herein, may incorporate the photosensor device according to the present invention, and the photosensor device may also be used in optical systems other than the optical compact disc player described herein.

**Claims**

1. A photosensor device (38) comprising:
   a rectangular package (1) carrying a plurality of pairs of terminal leads (9), each terminal lead (9) having an external portion (9a) extending outside of said package (1), said external portions (9a) being parallel to each other within a first plane and perpendicular to a first direction within said first plane;
   photosensing means (2) mounted on said package (1) and having a surface substantially parallel to said first plane; and
   a plurality of photosensitive elements (3E, 3S, 3L, 3M, 3F) formed on said surface and aligned thereon in a second direction;
   each pair of terminal leads (9) being electrically connected to a respective photosensitive element (3E, etc);
   characterized in that:
   said second direction is not parallel to a side of said package (1) and forms an angle (θ) with respect to a projection of said first direction onto said surface, said angle (θ) being other than nπ/2, where n equals zero or a positive integer.

2. A photosensor device (38) according to claim 1 wherein said photosensing means (2) has a rectangular cross-section in said surface and said second direction is parallel to a side of said rectangular cross-section.

3. A photosensor device (38) according to claim 1 wherein said photosensing means (2) has a rectangular cross-section in said surface, said second direction and a side of the rectangular cross-section includes said angle (θ), and said first direction is parallel to said side.

4. A photosensor device according to claim 1 wherein said angle (θ) is greater than 15° and is less than 75°.

5. A photosensor device (38) according to any one of the preceding claims wherein said photosensing means (2) is encapsulated within said package (1).

6. A photosensor device (38) according to claim 5 wherein at least a portion of said package (1) surrounding said photosensing means (2) is formed of a transparent material.

7. A photosensor device (38) according to any one of the preceding claims wherein said photosensing means (2) is a photosensing integrated circuit, said photosensitive elements (3E, etc.) are semiconductor photodiode elements formed in said integrated circuit, and said integrated circuit further includes non-photosensitive regions electrically isolating said photosensitive elements from each other.

8. A photosensor device (38) according to claim 1 or claim 9 wherein there are five of said photosensitive elements (3E, etc.).

9. A photosensor device (38) according to claim 1 wherein each of said photosensitive elements (3E, etc.) includes a photosensitive portion and an electrical contact portion, and each of said terminal leads (9) is electrically connected to the respective photosensitive element (3E, etc.) at said electrical contact portion of said photosensitive element (3E, etc.).

10. A photosensor device (38) according to claim 9 wherein each said electrical contact portion includes two electrical contacts respectively connected to first and second ones of the respective pair of terminal leads (9).

11. An optical pick-up device (50) for reproducing information signals recorded on a surface of a disc (26) in a substantially circular track, the device comprising:

a photosensor device (38) according to claim 1;

a laser source (31) for emitting a laser beam;

first optical means (32, 34) for producing three optical beams from said laser beam along respective incident optical paths substantially parallel to each other and to said disc surface and lying in a second plane which is at an acute angle to said disc surface;

mirror means (39) for reflecting said three optical beams to be incident on said track at locations spaced along a substantially tangential direction thereof and perpendicular to said disc surface, said three optical beams being reflected from said disc surface as return optical beams, said mirror means further reflecting said return optical beams; and second optical means (33) for deflecting each of said return optical beams by a predetermined angle to be aligned in said second direction and be incident on said photosensitive elements (3E, 3S, 3L, 3M, 3F).

12. An optical pick-up device (50) according to claim 11 wherein said first optical means (32, 34) includes diffraction grating (32) for splitting said laser beam into said three optical beams, and a collimating lens (34) for orientating said three optical beams to be parallel to each other.

13. An optical pick-up device (50) according to claim 11 or claim 12 further comprising a base plate (30), and wherein said laser source (31), said first optical means (32, 34), said mirror means (33a), said second optical means (39), and said photosensor means (38) are mounted on said base plate (30).

14. An optical pick-up device (50) according to claim 11, claim 12 or claim 13 wherein said three optical beams are incident on said disc surface at locations spaced along a direction tangential to said track.

15. An optical pick-up device according to any one of claims 11 to 14 wherein said second optical means (33) includes a half-mirror (33a) by which the return optical beams are directed to said photosensor means (38).

16. An optical pick-up device (50) according to claim 15 further comprising means (41, 41c) mounting said optical pick-up device (50) for movement radially with respect to said disc (26) such that said beams perpendicularly incident on said disc surface are moved in a radial direction of said disc (26).

17. An optical pick-up device (50) according to claim 16 further comprising a rectangular casing (40) enclosing at least said disc (26) and said optical pick-up device (50), said radial direction of said disc (26) being at an acute tilt angle (β) with respect to a second radial direction of said disc (26) perpendicular to a side of said rectangular casing (40).

18. An optical pick-up according to claim 17 wherein $\theta = (n\pi/2) + \beta$.

**Patentansprüche**

1. Photodetektoranordnung (38)

mit einer quaderförmigen Packung (1), die mehrere Paare von Anschlußleitern (9) trägt, die jeweils einen aus der Packung (1) herausragenden äußeren Abschnitt (9a) besitzen, wobei diese äußeren Abschnitte (9a) in einer ersten Ebene parallel zueinander und senkrecht zu einer ersten Richtung in dieser ersten Ebene verlaufen,

mit einem auf der Packung (1) montierten Photodetektor (2) mit einer im wesentlichen parallel zu der genannten ersten Ebene verlaufenden Fläche

sowie mit mehreren auf dieser Fläche ausgebildeten und auf ihr in einer zweiten Richtung fluchtenden Photodetektorelementen (3E, 3S, 3L, 3M, 3F),

wobei jedes Paar von Anschlußleitern (9) mit jeweils einem der Photodetektorelemente (3E usw.) elektrisch verbunden ist,

dadurch gekennzeichnet,

daß die genannten zweite Richtung zu keiner Seite der Packung (1) parallel ist und mit der Projektion der ersten Richtung auf die genannte Fläche einen Winkel (θ) bildet, der ungleich $n\pi/2$ ist, worin n gleich Null oder eine positive ganze Zahl ist.

2. Photodetektoranordnung (38) nach Anspruch 1, bei der der Photodetektor (2) in der genannten Fläche einen rechteckigen Querschnitt hat und bei der die zweite Richtung parallel zu einer Seite dieses rechteckigen Querschnitts verläuft.

3. Photodetektoranordnung (38) nach Anspruch 1, bei der der Photodetektor (2) in der genannten Fläche einen rechteckigen Querschnitt hat und bei der die zweite Richtung und eine Seite des recht-

teckigen Querschnitts den genannten Winkel (θ) einschließen und die erste Richtung zu dieser Seite parallel ist.

4. Photodetektoranordnung (38) nach Anspruch 1, bei der der Winkel (θ) größer als 15° und kleiner als 75° ist.

5. Photodetektoranordnung (38) nach einem der vorhergehenden Ansprüche, bei der der Photodetektor (2) in der Packung (1) verkapselt ist.

6. Photodetektoranordnung (38) nach Anspruch 5, bei der wenigstens ein Bereich der Packung (1), der den photodetektor (2) umschließt, aus transparentem Material besteht.

7. Photodetektoranordnung (38) nach einem der vorhergehenden Ansprüche, bei der der Photodetektor (2) eine photosensitive integrierte Schaltung ist, die Photodetektorelemente (3E usw.) in dieser integrierten Schaltung ausgebildete Halbleiterphotodioden sind und die integrierte Schaltung ferner Bereiche besitzt, die nicht photosensitiv sind und die photosensitiven Elemente elektrisch isolieren.

8. Photodetektoranordnung (38) nach Anspruch 1 oder 9, bei der fünf Photodetektorelemente (3E usw.) vorgesehen sind.

9. Photodetektoranordnung (38) nach Anspruch 1, bei der die Photodetektorelemente (3E usw.) einen photosensitiven Bereich und einen elektrischen Kontaktbereich haben und bei der jeder der genannten Anschlußleiter (9) mit dem betreffenden Photodetektorelement (3E usw.) in dem elektrischen Kontaktbereich dieses Photodetektorelements (3E usw.) verbunden ist.

10. Photodetektoranordnung (38) nach Anspruch 9, bei der jeder der elektrischen Kontaktbereiche zwei elektrische Kontakte besitzt, die mit dem ersten bzw. dem zweiten Anschlußleiter des betreffenden Paares von Anschlußleitern (9) verbunden ist.

11. Optische Abtastvorrichtung (50) für die Wiedergabe von Informationssignalen, die auf einer Oberfläche einer Platte (26) in einer im wesentlichen kreisförmigen Spur aufgezeichnet sind, bestehend aus

einer Photodetektoranordnung (38) nach Anspruch 1,

einer Laserquelle (21) zur Aussendung eines Laserstrahls,

einer ersten optischen Einrichtung (32, 34) zur Erzeugung dreier optischer Strahlen aus dem Laserstrahl, die längs entsprechender optischer Einfallspfade im wesentlichen parallel zueinander und zu der Plattenoberfläche verlaufen und in einer zweiten Ebene liegen, die mit der plattenoberfläche einen spitzen Winkel bildet,

einer Spiegeleinrichtung (39) zum Reflektieren der drei optischen Strahlen derart, daß sie an in einer im wesentlichen tangentialen Richtung voneinander beabstandeten Orten und senkrecht zu Oberfläche der Platte auf die genannte Spur auftreffen, wobei sie von der Oberfläche der Platte als rücklaufende optische Strahlen reflektiert werden, und wobei die Spiegeleinrichtung diese rücklaufenden optischen Strahlen weiter reflektiert,

und einer zweiten optischen Einrichtung (33) zur Ablenkung der einzelnen rücklaufenden optischen Strahlen um einen vorbestimmten Winkel, derart daß sie in der genannten zweiten Richtung fluchten und auf die Photodetektorelemente (3E, 3S, 3L, 3M, 3F) auftreffen.

12. Optische Abtastvorrichtung (50) nach Anspruch 12, bei der die erste optische Einrichtung (32, 34) ein Beugungsgitter (32) zur Aufteilung des Laserstrahls in die drei optischen Strahlen sowie eine Kollimatorlinse (34) zur parallelen Ausrichtung der drei optischen Strahlen aufweist.

13. Optische Abtastvorrichtung (50) nach Anspruch 11 oder 12 mit einer Basisplatte (30), auf der die Laserquelle (31), die erste optische Einrichtung (32, 34), die Spiegeleinrichtung (33a), die zweite optische Einrichtung (39) und die Photodetektoranordnung (38) montiert sind.

14. Optische Abtastvorrichtung (50) nach Anspruch 11, 12 oder 13, bei der die drei optischen Strahlen auf die Plattenoberfläche an Orten auftreffen, die in einer zu der Spur tangentialen Richtung Abstand voneinander haben.

15. Optische Abtastvorrichtung (50) nach einem der vorhergehenden Ansprüche 11 bis 14, bei der die zweite optische Einrichtung (33) einen halbdurchlässigen Spiegel (33a) umfaßt, durch den die rücklaufenden optischen Strahlen auf die Photodetektoranordnung (38) gerichtet werden.

16. Optische Abtastvorrichtung (50) nach Anspruch 15 mit Mitteln (41, 41c) für die Montage der optischen Abtastvorrichtung (50), mittels derer diese radial zu der Platte (26) derart bewegbar ist, daß die senkrecht auf die Plattenoberfäche auftreffenden Strahlen in radialer Richtung auf der Platte (26) bewegt werden.

17. Optische Abtastvorrichtung (50) nach Anspruch 16, bei der ferner ein quaderförmiges Gehäuse (40) vorgesehen ist, das zumindest die Platte (26) und die optische Abtastvorrichtung (50) umschließt, wobei die radiale Richtung der Platte (26) mit einer zweiten, zu einer Seite des quaderförmigen Gehäuses (40) senkrechten radialen Richtung einen spitzen Neigungswinkel (ß) bildet.

18. Optische Abtastvorrichtung (50) nach Anspruch 17, bei der der Winkel θ gleich (nπ/2)+ß ist.

## Revendications

1. Photocapteur (38) comprenant:

un boîtier rectangulaire (1) portant plusieurs paires de fils de connexion (9), chaque fil de connexion (9) ayant une partie externe (9a) qui dépasse du boîtier (1), les parties externes (9a) étant parallèles les unes aux autres dans un premier plan et perpendiculaires à une première direction dans le premier plan,

un dispositif de photodétection (2) monté sur le boîtier (1) et ayant une surface sensiblement parallèle au premier plan, et

plusieurs éléments photosensibles (3E, 3S, 3L, 3M, 3F) formés sur ladite surface et alignés sur celle-ci dans une seconde direction,

chaque paire de fils de connexion (9) étant connectée électriquement à un élément photosensible respectif (3E, etc.),

caractérisé en ce que:

la seconde direction n'est pas parallèle à un côté du boîtier (1) et forme un angle (θ) avec une projection de la première direction sur ladite surface, l'angle (θ) étant différent de nπ/2, n étant égal à 0 ou étant un nombre entier positif.

2. Photocapteur (38) selon la revendication 1, dans lequel le dispositif de photodétection (2) a une section rectangulaire à ladite surface et la seconde direction est parallèle à un côté de cette section rectangulaire.

3. Photocapteur (38) selon la revendication 1, dans lequel le dispositif de photodétection (2) a une section rectangulaire à ladite surface, la seconde direction et un côté de la section rectangulaire faisant ledit angle (θ), et la première direction est parallèle à ce côté.

4. Photocapteur selon la revendication 1, dans lequel ledit angle (θ) est supérieur à 15° et inférieur à 75°.

5. Photocapteur (38) selon l'une quelconque des revendications précédentes, dans lequel le dispositif de photodétection (2) est enrobé dans le boîtier (1).

6. Photocapteur (38) selon la revendication 5, dans lequel une partie au moins du boîtier (1) qui entoure le dispositif de photodétection (2) est formé d'un matériau transparent.

7. Photocapteur (38) selon l'une quelconque des revendications précédentes, dans lequel le dispositif de photodétection (2) est un circuit intégré de photodétection, les éléments photosensibles (3E, etc.) sont des éléments formant des photodiodes à semi-conducteur dans le circuit intégré, et le circuit intégré comporte en outre des régions non photosensibles qui isolent électriquement les éléments photosensibles les uns des autres.

8. Photocapteur (38) selon la revendication 1 ou 9, dans lequel le nombre d'éléments photosensibles (3E, etc.) est égal à cinq.

9. Photocapteur (38) selon la revendication 1, dans lequel chaque élément photosensible (3E, etc.) a une partie photosensible et une partie de contact électrique, et chacun des fils de connexion (9) est connecté électriquement à l'élément photosensible respectif (3E, etc.) dans la partie de contact électrique de l'élément photosensible (3E, etc.).

10. Photocapteur (38) selon la revendication 9, dans lequel chaque partie de contact électrique comporte deux contacts électriques connectés respectivement au premier et au second des fils de connexion (9) de la paire respective.

11. Détecteur optique (50) destiné à restituer des signaux d'information enregistrés à la surface d'un disque (26) dans une piste sensiblement circulaire, le détecteur comprenant:

un photocapteur (38) selon la revendication 1,

une source laser (31) destinée à émettre un faisceau laser,

un premier dispositif optique (32, 34) destiné à former trois faisceaux optiques à partir du faisceau laser, suivant des trajets optiques respectifs d'incidence qui sont sensiblement parallèles les uns aux autres et à la surface du disque et qui se trouvent dans un second plan qui fait un angle aigu avec la surface du disque,

un dispositif (39) à miroir destiné à réfléchir les trois faisceaux optiques afin qu'ils tombent sur la piste à des emplacements espacés en direction sensiblement tangentielle à la piste et perpendiculairement à la surface du disque, les trois faisceaux optiques étant réfléchis par la surface du disque sous forme de faisceaux optiques renvoyés, le dispositif à miroir réfléchissant à nouveau les faisceaux optiques renvoyés, et

un second dispositif optique (33) destiné à dévier chacun des faisceaux optiques renvoyés d'un angle prédéterminé afin qu'ils soient alignés dans la seconde direction et tombent sur les éléments photosensibles (3E, 3S, 3L, 3M, 3F).

12. Détecteur optique (50) selon la revendication 11, dans lequel le premier dispositif optique (32, 34) comporte un réseau de diffraction (32) destiné à séparer le faisceau laser en trois faisceaux optiques, et une lentille collimatrice (34) destinée à orienter les trois faisceaux optiques afin qu'ils soient parallèles les uns aux autres.

13. Détecteur optique (50) selon la revendication 11 ou 12, comprenant en outre une plaque de base (30), et dans lequel la source laser (31), le premier dispositif optique (32, 34), le dispositif à miroir (33a), le second dispositif optique (39) et le photocapteur (38) sont montés sur la plaque de base (30).

14. Détecteur optique (50) selon la revendication 11, 12 ou 13, dans lequel les trois faisceaux optiques tombent à la surface du disque à des emplacements espacés en direction tangente à la piste.

15. Détecteur optique selon l'une quelconque des revendications 11 à 14, dans lequel le second dispositif optique (33) comporte un miroir semi-réfléchissant (33a) grâce auquel les faisceaux optiques renvoyés sont dirigés vers le photocapteur (38).

16. Détecteur optique (50) selon la revendication 15, comprenant en outre un dispositif (41, 41c) de montage du détecteur optique (50) afin qu'il se déplace radialement par rapport au disque (26), si bien que les faisceaux tombant perpendiculairement à la surface du disque se déplacent dans une direction radiale du disque (26).

17. Détecteur optique (50) selon la revendication 16, comprenant en outre un carter rectangulaire (40) entourant au moins le disque (26) et le détecteur optique (50), la direction radiale du disque (26) faisant un angle aigu (ß) avec une seconde direction radiale du disque (26) qui est perpendiculaire à un côté du carter rectangulaire (40).

18. Détecteur optique selon la revendication 17, caractérisé en ce que $\theta = (n\pi/2) + \beta$.

FIG.1

FIG.2

## FIG.3

## FIG.4

## FIG.5

## FIG.6

# FIG.7

3E   3S  3L  3M    3F

100

N⁺   P⁺   P⁺  P⁺ P⁺ P⁺   P⁺   N⁺

N⁺        N⁺  N⁺ N⁺   N⁺

N⁻

N⁺⁺

2

100a

4

# FIG.9

T

46

45

44

44

47

# FIG.8

38'

II

9'

9a

101

9a   9

102

15

12

13E
13S

Y

13L
13M

13F   15

9a   9

9a   9